# EUROPEAN PATENT APPLICATION

(11) **EP 4 766 130 A1**
(43) Date of publication of application: **24.06.2026**
(21) Application number: 25211688.4
(22) Date of filing: 28.10.2025
(51) Int. Cl.: H10P 90/00

(54) **METHOD OF FABRICATING A SILICON ON INSULATOR SUBSTRATE**

(30) Priority: 18.12.2024 KR 20240189854
(71) Applicant: SK hynix Inc., Bubal-eub Icheon-si Gyeonggi-do 17336 (KR)
(72) Inventor: CHO, Hae Woo, 17336 Icheon-si, Gyeonggi-do (KR); LEE, Ji Hye, 17336 Icheon-si, Gyeonggi-do (KR)
(74) Representative: Isarpatent

(57) **Abstract**

According to a method of fabricating an SOI substrate, a stopper layer, a semiconductor layer, a buried insulating layer and a first bonding insulation layer are sequentially formed on a sacrificial wafer. A second bonding insulation layer is formed on a reference wafer. The first and second bonding insulation layers include a Silicon Carbon Nitride (SiCN) material. Si-OH bonds are formed in the first bonding insulation layer and the second bonding insulation layer by an O2 plasma treatment. The sacrificial wafer is bonded to the reference wafer so that the first bonding insulation layer contacts the second bonding insulation layer.

## Description

### BACKGROUND

### 1. Technical Field

Embodiments of the present disclosure relate to a method of fabricating a silicon on insulator (SOI) substrate, and more specifically to a method of fabricating an SOI substrate for improving a bonding strength of a wafer bonding interface.

### 2. Related Art

A direct wafer bonding may be a technology that directly bonds two wafers with completely flat surfaces to each other without using any adhesive, such as a paste and a glue. This bonding technology may be used in a fabrication of a silicon on insulator (SOI) substrate.

However, the direct wafer bonding technique that bonds the two wafers (or substrates) without the adhesive may cause a variety of defects.

For example, the defects include a void at a bonding interface of the two wafers, an edge void in a thin layer of a final structure (i.e., SOI substrate), and a bonding error due to a low bonding strength in the bonding interface. These defects may adversely affect properties of semiconductor devices fabricated using the SOI substrate.

As a result, there is a need for a technology to suppress wafer edge voids, suppress voids between the bonding interfaces of wafers, and strengthen the bonding strength of the bonding interface during fabricating the SOI substrate.

### SUMMARY

Embodiments of the present disclosure provide a method of fabricating a SOI substrate that may be capable of reducing voids formed at a bonding interface of wafers.

Embodiments of the present disclosure provide a method of fabricating a SOI substrate that may be capable of improving bonding strength of the bonding interface of the wafers.

According to an embodiment of the present disclosure, there may be provided a method of fabricating an SOI substrate. A stopper layer, a semiconductor layer, a buried insulating layer and a first bonding insulation layer including a Silicon Carbon Nitride (SiCN) material may be sequentially formed on a sacrificial wafer. A second bonding insulation layer including the SiCN material may be formed on a reference wafer. Si-OH bonds may be formed in the first bonding insulation layer and the second bonding insulation layer by an O₂ plasma treatment and scrubbing of the first bonding insulation layer and the second bonding insulation layer. The sacrificial wafer may be bonded to the reference wafer to form a bonding structure such that the first bonding insulation layer and the second bonding insulation layer face each other. The bonding structure may then be annealed.

According to an embodiment of the present disclosure, there may be provided a method of fabricating an SOI substrate. A stopper layer, a semiconductor layer, a buried insulating layer and a first bonding insulation layer may be sequentially formed on a sacrificial wafer to generate a first structure. A second bonding insulation layer may be formed on a reference wafer to generate a second structure. Si-OH bonds may be formed in the first bonding insulation layer and the second bonding insulation layer. The first structure and the second structure may be bonded to form a bonding structure such that the first bonding insulation layer is bonded to the second bonding insulation layer

According to embodiments of the present disclosure, by using the SiCN as a wafer bonding insulation layer, it may be possible to effectively adsorb an H₂ gas outgassing from the sacrificial wafer during high temperature annealing after bonding, thereby inhibiting formations of voids at the interface between the bonding insulation layers.

Further, the O₂ plasma treatment of the SiCN may break the Si-C bonds and may scrub to form the Si-OH bonds to induce van der Waals hydrogen bonds (Si-OH---OH-Si) between the bonding insulation layers, by changing the van der Waals hydrogen bonds (Si-OH-OH-Si) into Si-O-Si covalent bonds through the annealing, the bonding may be strengthened by decreasing the bond length and decreasing an interfacial gap between the bonding insulation layers.

Furthermore, by bonding the sacrificial and reference wafers at a room temperature after a helium gas injection for a set period of time, the generation of wafer edge voids due to the Joule-Thomson effect may be prevented.

### BRIEF DESCRIPTION OF THE DRAWINGS

The above and another aspects, features, and advantages of the embodiments of the present disclosure will be more clearly understood from the following detailed description taken in conjunction with the accompanying drawings, in which:
FIG. 1 is a flow chart illustrating a method of fabricating an SOI substrate in accordance with embodiments of the present disclosure; and
FIGS. 2 to 10 are cross-sectional views illustrating a method of fabricating SOI substrates in accordance with embodiments of the present disclosure.

### DETAILED DESCRIPTION

Various embodiments of the present disclosure will be described in greater detail with reference to the accompanying drawings. The drawings are schematic illustrations of various embodiments and intermediate structures. As such, variations from the configurations and shapes of the illustrations as a result, for example, of manufacturing techniques and/or tolerances, are to be expected. Thus, the described embodiments should not be construed as being limited to the particular configurations and shapes illustrated herein but may include deviations in configurations and shapes which do not depart from the spirit and scope of the present disclosure as defined in the appended claims.

The embodiments of the present disclosure are described herein with reference to cross-section and/or plan illustrations of the embodiments. However, embodiments of the present disclosure should not be construed as limiting the inventive concept. Although a few embodiments of the present disclosure will be shown and described, it will be appreciated by those of ordinary skill in the art that changes may be made in these embodiments without departing from the principles and spirit of the present disclosure.

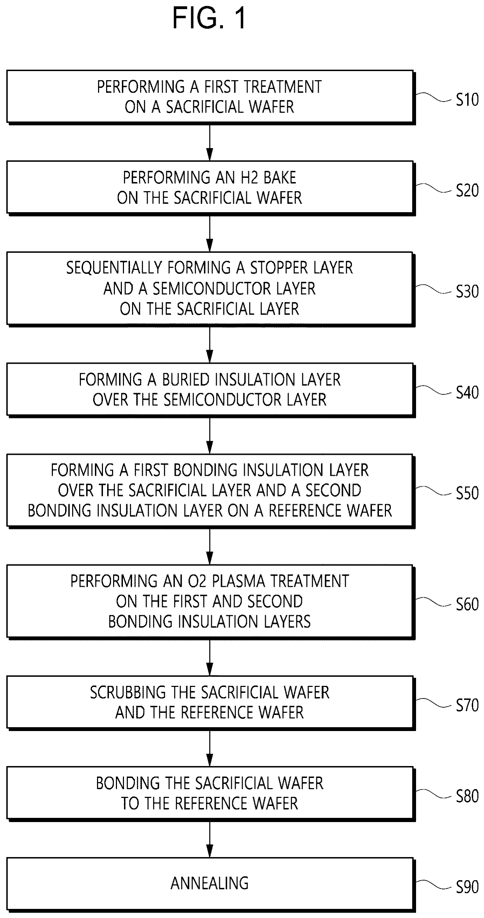

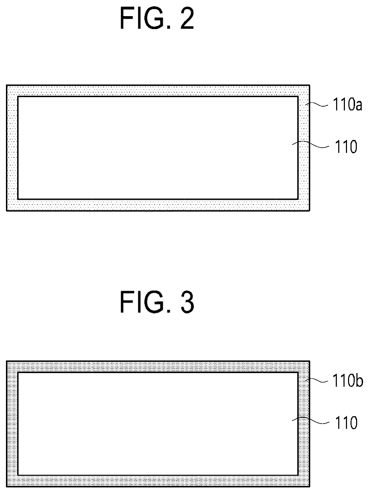

FIG. 1 is a flow chart illustrating a method of fabricating an SOI substrate in accordance with embodiments of the present disclosure. FIGS. 2 to 10 are cross-sectional views illustrating a method of fabricating an SOI substrate in accordance with embodiments of the present disclosure.

Referring to FIGS. 1 and 2, a first treatment may be performed on a sacrificial wafer 110 (S10). For example, the first treatment may include a first cleaning process. The sacrificial wafer 110 may include at least one material selected from silicon (Si), germanium (Ge), silicon carbide (SiC), IV-IV group, III-V group, or II-VI group semiconductor compounds, and piezoelectric materials (e.g., LiNbO₃, LiTaO₃, etc.).

In some embodiments, the first treatment may include cleaning the sacrificial wafer 110 using a SC1 solution (NH₄OH:H₂O₂:H₂O). During the cleaning of the sacrificial wafer 110, an oxide layer 110a including impurities (or residues) on a surface of the sacrificial wafer 110 is removed. The surface of the sacrificial wafer 110 may include an upper surface, a bottom surface and sidewalls. For example, the oxide layer 110a including the impurities may be formed on the surface of the sacrificial wafer 110 by H₂O₂ component of the SC1 solution. In some embodiments, the oxide layer 110a including the impurities may be removed by the NH₄OH component with a property of etching an oxide material in the SC1 solution. Thus, the impurities existing on the surface of the sacrificial wafer 110 may be firstly removed.

The impurities remaining on the surface of the sacrificial wafer 110 may be removed by the oxide layer 110a generated by the first treatment. Referring to FIG. 1 and FIG. 3, a chemical oxide layer 110b generated as a by-product by H₂O₂ of the SC1 solution during the first treatment may remain despite the NH₄OH component of the SCl solution.

The sacrificial wafer 110 may be performed by a H₂ bake process under a high temperature. (S20). Accordingly, the chemical oxide layer 110b on the surface of the sacrificial wafer 110 may be removed by the H₂ bake process. For example, impurities in a bevel region of the sacrificial wafer 110 may be effectively removed by the H₂ bake process. Thus, dislocation defects due to lattice mismatch may be reduced by removing the impurities in the bevel region of the sacrificial wafer 110.

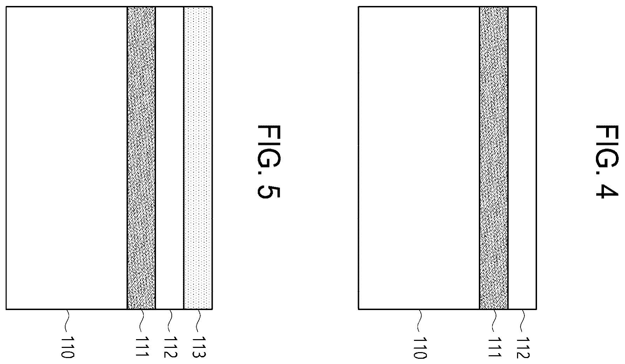

Referring to FIGS. 1 and 4, a stopper layer 111 and a semiconductor layer 112 may be sequentially formed on the sacrificial wafer 110 using an epitaxial growth process (S30). In some embodiments, the stopper layer 111 and the semiconductor layer 112 may be formed by an in-situ process.

For example, the stopper layer 111 may prevent the semiconductor layer 112 from being removed, when the sacrificial wafer 110 may be removed from a bonding structure to be performed later. The stopper layer 111 may be formed using a material having a different etching selectivity from an etching selectivity of the sacrificial wafer 110 and the semiconductor layer 112. Further, the stopper layer 111 may be formed using a material with a small difference in properties from the semiconductor layer 112. In some embodiments, the stopper layer 111 may include a single crystalline silicon germanium (SiGe) layer, and the semiconductor layer 112 may include a single crystalline silicon (Si) layer.

Referring to FIGS. 1 and 5, a buried insulation layer 113 may be formed over the semiconductor layer 112 (S40). For example, the buried insulation layer 113 may include, but is not limited to, a silicon oxide (SiO₂) layer.

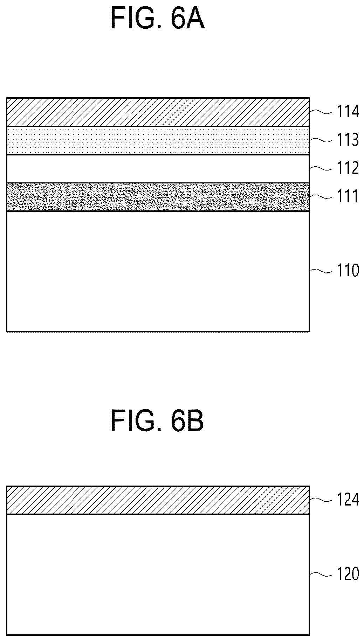

Referring to FIGS. 1, 6A and 6B, a first bonding insulation layer 114 may be formed over the sacrificial wafer 110. Further, a reference wafer 120 is prepared. A second bonding insulation layer 124 may be formed on the reference wafer 120 (S50). In some embodiments, the first bonding insulation layer 114 may be formed to contact the buried insulation layer 113 over the sacrificial wafer 110. The second bonding insulation layer 124 may be formed on a surface of the reference wafer 120. The reference wafer 120 may include at least one material selected from Si, Ge, SiC, IV-IV group, III-V group, or II-VI group semiconductor compounds, and piezoelectric materials (e.g., LiNbO₃, LiTaO₃, etc.).

For example, forming the first bonding insulation layer 114 on the buried insulation layer 113 and forming the second bonding insulation layer 124 on the reference wafer 120 may be performed alternately in a same chamber, or may be performed simultaneously in a same chamber, or may be performed simultaneously in different chambers.

In some embodiments, the first bonding insulation layer 114 and the second bonding insulation layer 124 may include a silicon carbon nitride (SiCN) layer. For example, the first bonding insulation layer 114 and the second bonding insulation layer 124 may be formed by a plasma-enhanced chemical vapor deposition (PECVD) process, respectively. When the first bonding insulation layer 114 and the second bonding insulation layer 124 are formed in a PECVD chamber, tetramethylsilane (TMS) gas, nitrogen (N₂) gas, and helium (He) gas are provided to the PECVD chamber, to stabilize the first bonding insulation layer 114 as a plasma treatment.

By way of example and without any limitation, a carbon (C) concentration ratio of each of the first and second bonding insulation layers 114 and 124 may be greater than about 36%. As the carbon (C) concentration ratio of each of the first and second bonding insulating layers 114 and 124 increases, the number of Si dangling bonds generated in each of the first and second bonding insulating layers 114 and 124 during a subsequent Oxygen (O₂) plasma treatment may also increase. Thus, the H₂ gas generated and remaining in the H₂ bake process and outgassed may be more effectively adsorbed to suppress voids.

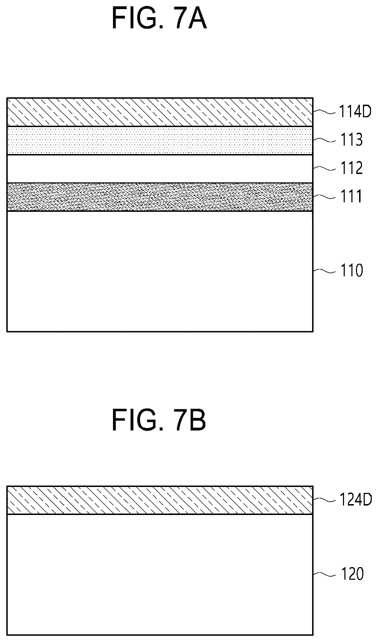

Referring to FIGS. 1, 7A and 7B, the O₂ plasma treatment may be performed on the first bonding insulation layer 114 and the second bonding insulation layer 124 (S60). For example, an O₂ gas may be injected into a process chamber, for example, a plasma chamber. Then, the process chamber is stabilized for a period of time, for example, about 30 seconds. Thereafter, a HF power of 50W to 400W may be applied to the process chamber for a set time period, for example, 10 seconds, and then the first bonding insulation layer 114 and the second bonding insulation layer 124 may be performed by the O₂ plasma treatment respectively

Si-C bonds of each of the first and second bonding insulation layers 114 and 124 which include the SiCN material are desorbed from carbon (C) by the O₂ plasma treatment. Accordingly, first and second bonding insulation layers 114D and 124D have a higher content of silicon dangling bonds than the SiCN material before the O₂ plasma treatment.

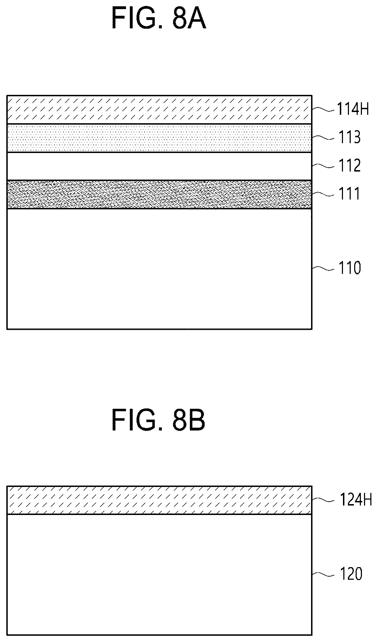

Referring to FIGS. 1, 8A and 8B, the sacrificial wafer 110 and the reference wafer 120 may be scrubbed to remove particles (S70). For example, the particles resulting from previous processes may be generated on surfaces of the sacrificial wafer 110 and the reference wafer 120 after the O₂ plasma treatment. The scrubbing process (S70) of the sacrificial wafer 110 and the reference wafer 120 may include a rinse process and a drying process. For example, the rinse process may be performed by a deionized water (DIW). The drying process may be performed by an N₂ dryer for a period of time (e.g., about 30 seconds). For example, the scrubbing process may be performed in a scrubber.

As OH bonds of the H₂O provided by the DIW are adsorbed on the Si dangling bonds of the first and second bonding insulation layers 114D and 124D in FIGS. 7A and 7B, first and second bonding insulation layers 114H and 124H having Si-OH bonds may be formed, as shown in FIGS. 8A and 8B.

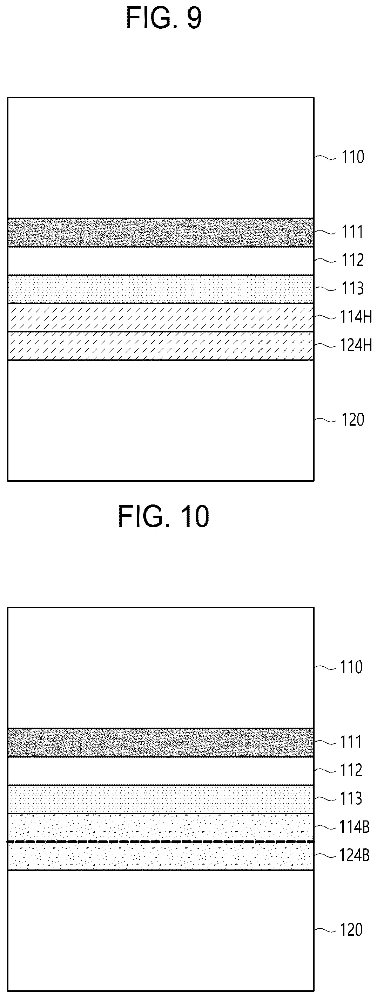

Referring to FIGS. 1 and 9, a structure of the sacrificial wafer 110, the stopper layer 111, the semiconductor layer 112, the buried insulation layer 113 and the first bonding insulation layer 114H may be flipped over. The flipped structure may be bonded onto a structure of the reference wafer 120 and the second bonding insulation layer 124H (S80).

For example, the sacrificial wafer 110 may be chucked face-down on the upper chuck (not shown) of a bonding apparatus (not shown) and the reference wafer 120 may be chucked on the lower chuck (not shown) of the bonding apparatus. In this embodiment, the sacrificial wafer 110 and the reference wafer 120 may be chucked onto the upper chuck and the lower chuck in a vacuum adsorption manner.

In some embodiments, a helium gas may be injected into the process chamber for a set time period (e.g., about 35 seconds or more) while the sacrificial wafer 110 and the reference wafer 120 may be chucked on the upper chuck and the lower chuck, respectively. After the set time period, the vacuum in the upper chuck on which the sacrificial wafer 110 may be chucked may be released, allowing the sacrificial wafer 110 to detach from the upper chuck and fall onto the reference wafer 120 for bonding.

As such, by injecting the helium gas with a negative Joule-Thomson coefficient for a set period of time prior to bonding the sacrificial wafer 110 and the reference wafer 120, generations of edge voids due to a Joule-Thomson effect may be suppressed.

Further, as the sacrificial wafer 110 and the reference wafer 120 may be bonded to each other such that the first and second bonding insulation layers 114H and 124H having Si-OH bonds contact each other, as described above, the first bonding insulation layer 114H and the second bonding insulation layer 124H may be bonded by van der Waals hydrogen bonds (Si-OH---OH-Si) between the Si-OH bonds of the first bonding insulation layer 114H and the Si-OH bonds of the second bonding insulation layer 124H on the reference wafer 120. As a result, a bonding structure including the second bonding insulation layer 124H and the first bonding insulation layer 114H bonded by the van der Waals hydrogen bonds (Si-OH---OH-Si), the buried insulating layer 113, the semiconductor layer 112, the stopper layer 111, and the sacrificial wafer 110 arranged sequentially on the reference wafer 120 may be formed.

Referring to FIGS. 1 and 10, the bonding structure may be processed by an annealing process (S90). By way of example and without any limitation, the annealing process may be performed at about 430°C. In some embodiments, as the annealing process is performed at a high temperature, H₂O may escape from a van der Waals hydrogen bond (Si-OH---OH-Si) between the first bonding insulation layer 114H and the second bonding insulation layer 124H to form a Si-O-Si covalent bond, thereby reducing a length of the bond. Accordingly, an interfacial gap between the first and second bonding insulation layers 114B and 124B may be reduced, thereby enhancing the bond strength, as shown in FIG. 10.

As described in S20 of FIG. 1, a H₂ thermal treatment at a high temperature may be performed to remove the chemical oxide layer 110b on the surface of the sacrificial wafer 110. In this operation, the H₂ gas may be stored in the sacrificial wafer 110 at the same time as the chemical oxide layer 110b may be removed. There may be a concern that the H₂ gas stored in the sacrificial wafer 110 may be outgassed to a bonding interface (e.g., a portion of the bonding surface between the first bonding insulation layer and the second bonding insulation layer) having a relatively weak bonding strength during the high temperature annealing, resulting in the formation of voids. However, in some embodiments, the outgassed H₂ may be effectively adsorbed on N bonds of the SiCN material used as the bonding insulation layers 114B and 124B, thereby preventing the formation of a void at the bonding interface between the bonding insulation layers 114B and 124B.

As described above, in some embodiments, the bonding insulation layer may be formed with the SiCN over each of the sacrificial wafer 110 and the reference wafer 120, the O₂ plasma treatment may be performed on the SiCN to form the Si dangling bond, and the OH may be adsorbed on the Si dangling bond during the scrubbing process to form the bonding insulation layer having Si-OH bonds. The bonding insulation layers having Si-OH bonds may be bonded by van der Waals hydrogen bonds (Si-OH---OH-Si), and upon the annealing process, the Si-O-Si covalent bonds may be formed as the H₂O escapes from the van der Waals hydrogen bonds (Si-OH---OH-Si). As such, the interfacial gap between the bonding insulation layers may be reduced as the bond length decreases, thereby strengthening the bonding between the bonding insulation layers. In some embodiments and without any limitation, the bonding strength between the bonding insulation layers after completion of annealing process may be 1.8 J/m² or more.

In some embodiments, once the annealing process of the bonding structure may be complete, the sacrificial wafer 110 and stopper layer 111 may be sequentially removed to complete fabrication of the SOI substrate.

For example, the sacrificial wafer 110 disposed on the bonding structure may have a part of an edge removed through a wafer trimming before the bonding process of the sacrificial wafer 110 and the reference wafer 120. Then, the sacrificial wafer 110 may be removed through a grinding process after the bonding and annealing processes so that the sacrificial wafer 110 has a set thickness (or height). Thereafter, a remaining sacrificial wafer and the stopper layer 111 may be sequentially removed.

The remaining sacrificial wafers may be removed using a wet cleaning process and a dry cleaning process. For example, the remaining sacrificial wafer may be removed by successively performing a Dilute hydrofluoric acid (DHF) pretreatment cleaning process and a wet alkaline (Diluted NH₄OH, TMAH: (CH₃)₄N(OH), KOH, etc.) post-treatment cleaning process, followed by the drying process in an IPA Dryer. Furthermore, the stopper layer 111 may be removed using the wet cleaning process and the dry cleaning process. For example, the stopper layer 111 may be removed by a wet alkaline (Diluted NH₄OH, TMAH: (CH₃)₄N(OH), KOH, etc.) cleaning process and a dry cleaning process using fluorinated compounds.

As described above, by sequentially removing the remaining sacrificial wafer and stopper layer 111, fabrication of the SOI substrate including the reference wafer 120 and the second bonding insulation layer 124, the first bonding insulation layer 114, the buried insulating layer 113, and the semiconductor layer 112 sequentially stacked on the reference wafer 120 may be completed.

The above described embodiments of the present disclosure are intended to illustrate and not to limit the present invention. Various alternatives and equivalents are possible. The embodiments of the present disclosure are not limited by the embodiments described herein. Nor are the embodiments limited to any specific type of semiconductor device. Other additions, subtractions, or modifications are possible in view of the present disclosure and are intended to fall within the scope of the appended claims. Furthermore, the embodiments may be combined to form additional embodiments.

## Claims

1. A method of fabricating a silicon on insulator (SOI) substrate, the method comprising:
sequentially forming, on a sacrificial wafer, a stopper layer, a semiconductor layer, a buried insulating layer and a first bonding insulation layer including a Silicon Carbon Nitride (SiCN) material;
forming a second bonding insulation layer including the SiCN material on a reference wafer;
forming Si-OH bonds in the first bonding insulation layer and the second bonding insulation layer, by performing an O₂ plasma treatment and scrubbing of the first bonding insulation layer and the second bonding insulation layer, respectively;
bonding the sacrificial wafer and the reference wafer to form a bonding structure such that the first bonding insulation layer and the second bonding insulation layer face each other; and
annealing the bonding structure.

2. The method of claim 1, further comprising:
cleaning the sacrificial wafer before forming the stopping layer on the sacrificial wafer.

3. The method of claim 2,
wherein cleaning the sacrificial wafer comprises:
cleaning the sacrificial wafer using a SC1 solution (NH₄OH:H₂O₂:H₂O), wherein an oxide layer including impurities is formed on a surface of the sacrificial wafer, and then removed during the cleaning of the sacrificial wafer; and
removing a chemical oxide layer formed on the sacrificial wafer by a H₂ bake treatment at high temperature on the sacrificial wafer.

4. The method of claim 1,
wherein at least one of the stopper layer and the semiconductor layer is formed by an epitaxial growth process on the sacrificial wafer.

5. The method of claim 1,
wherein the stopper layer comprises single crystalline silicon germanium (SiGe), and
wherein the semiconductor layer comprises single crystalline silicon (Si).

6. The method of claim 1,
wherein forming the Si-OH bonds in the first bonding insulation layer and the second bonding insulation layer comprises:
changing Si-C bonds of the first bonding insulation layer and the second bonding insulation layer into Si dangling bonds by performing the O₂ plasma treatment; and
adsorbing OH bonds onto the Si dangling bond using H₂O provided by the scrubbing.

7. The method of claim 1,
wherein forming the bonding structure comprises:
flipping the sacrificial wafer over and chucking the sacrificial wafer into an upper chuck of a bonding apparatus;
chucking the reference wafer into a lower chuck of the bonding apparatus;
injecting a He gas into the bonding apparatus; and
dechucking the sacrificial wafer from the upper chuck so that the sacrificial wafer is bonded to the reference wafer.

8. The method of claim 1,
wherein the O₂ plasma treatment comprises:
injecting an O₂ gas into a process chamber;
stabilizing the process chamber; and
applying HF power to the O₂ gas.

9. The method of claim 1,
wherein at least one of the first and second bonding insulation layers include a SiCN layer formed through a plasma-enhanced chemical vapor deposition (PECVD) process, and
wherein each of the first and second bonding insulation layers is formed through a plasma treatment after stabilization by injecting a tetramethylsilane (TMS) gas, a nitrogen gas and a helium gas.

10. The method of claim 1,
wherein a carbon (C) concentration ratio of the SiCN material is no less than 36%.

11. The method of claim 1, further comprising:
sequentially removing the sacrificial wafer and the stopper layer from the bonding structure after annealing the bonding structure.

12. The method of claim 11,
wherein the sacrificial wafer and the stopper layer are removed using a wet cleaning process and a dry cleaning process, respectively.

13. A method of fabricating a silicon on insulator (SOI) substrate, the method comprising:
sequentially forming, on a sacrificial wafer, a stopper layer, a semiconductor layer, a buried insulating layer and a first bonding insulation layer to generate a first structure;
forming a second bonding insulation layer on a reference wafer to generate a second structure;
forming Si-OH bonds in the first bonding insulation layer and the second bonding insulation layer; and
bonding the first structure and the second structure to form a bonding structure such that the first bonding insulation layer is bonded to the second bonding insulation layer.

14. The method of claim 13, further comprising:
annealing the bonding structure.
